# EUROPEAN PATENT APPLICATION

(11) **EP 4 730 395 A1**
(43) Date of publication of application: **22.04.2026**
(21) Application number: 24206655.3
(22) Date of filing: 15.10.2024
(51) Int. Cl.: H01L 21/50, H01L 23/10, H01L 23/053

(54) **A METHOD FOR FABRICATING A SEMICONDUCTOR MODULE COMPRISING AT LEAST ONE MOLDED SILICONE SEALING**

(71) Applicant: Infineon Technologies AG, 85579 Neubiberg (DE)
(72) Inventor: TROSKA, Georg, 58730 Fröndenberg (DE); STEININGER, Christian, 59494 Soest (DE)
(74) Representative: Lambsdorff & Lange Patentanwälte Partnerschaft mbB

(57) **Abstract**

A method for fabricating a semiconductor module comprises providing a substrate (1) comprising a ceramic layer (1A), a first metallic layer (1B) disposed on a first face of the ceramic layer (1A), and a second metallic layer (1C) disposed on a second face of the ceramic layer (1A), connecting a semiconductor die (2) to the first metallic layer (1B) of the substrate (1), applying a closed sealing ring (3) to a cover part (4), connecting the cover part (4) to the substrate (1) so that the closed sealing ring (3) is connected with the ceramic layer (1A) of the substrate (1), covering the semiconductor die (2) and the substrate with an encapsulant (5), and curing the encapsulant (5).

## Description

### TECHNICAL FIELD

The present disclosure is related to a method for fabricating a semiconductor module and a semiconductor module.

### BACKGROUND

There are different kind of connections possible in order to seal a volume against another one. Regarding semiconductor power modules the main function of the glue between a module housing and the lower part of a module such as a substrate is to keep a non-cured volume of dielectric gel in the inside of the housing of the module. Alternative sealing concepts such as compound sealings are very interesting in order to reduce production costs.

Today, static sealings which are attached to a housing material in a 2C LSR process (2 Component Liquid Silicone Rubber) by using an automated injection molding process with a rotary form are state of the art. Unfortunately, because this kind of sealing typically has no adhesive properties, it can only be used for semiconductor power modules when there is an alternative mechanical connection between the housing and the lower part of the module, as a compressive force is needed for a functional sealing. Typically, this kind of mechanical connection is realized by screws or rivets. In the case of baseplateless modules, however, it is typically not feasible to use these kinds of fasteners to secure the housing to the lower part of the module prior to module installation.

For these and other reasons there is a need for the present disclosure.

### SUMMARY

The disclosure offered here, allows a possibility to connect a baseplateless semiconductor power module to a housing by introducing new design elements at the housing.

In general, two basic module topologies are conceivable. The one is a semiconductor power module using one or many substrates with semiconductors attached on the upper side, which are connected by standard connection technologies. These substrates are glued to the bottom side of a housing by using a compound sealing. In this case the glue acts as a sealing for the non-cured dielectric gel, which needs to be filled into the cavity created by the substrate and the housing and needs to be cured afterwards. On the other hand, this glue will also create a mechanical connection between substrate and housing. Because of this mechanical connection, tensile forces between substrate and housing are possible after the curing process.

The second topology is a semiconductor power module using the topology of substrates as described before, but here the substrates are connected (usually by a soldering or sintering technique) to a common baseplate. Interconnections between substrates are possible. It is typical for this kind of topology that the connection between the baseplate and the housing is created by rivets or screws and the sealing against the dielectric gel is realized by a compound sealing.

All conceivable topologies have a housing in common. The housing is typically a thermoplastic part which is created by injection molding processes. The housing typically consists of sidewalls and, optionally, an integrally formed or removable lid. It is created in such a way that it can be attached to a baseplate or a substrate in order to create an enclosed volume above the semiconductor devices. In subsequent process steps this volume is usually filled by a dielectric gel in order to improve required electrical properties (such as isolation or creepage distances).

The 2C LSR process offers the opportunity to create a housing for a semiconductor power module including a sealing against the liquid dielectric gel. One can directly see, that a replacement of the compound sealing by using a sealing which is a part of the housing (in 2C LSR technology) is only realizable for the second topology of power modules, as the first topology offers no possibility to create compressive forces on the sealing.

Since, as already mentioned, the mechanical connection between the substrate and the cover part by means of screws or rivets is not possible for substrates without a base plate, the present disclosure takes a different approach, as will be explained below.

The essence of the present disclosure is to provide the possibility to create a static sealing to a baseplateless module without further mechanical elements like screws or rivets. Further elements (e.g. snap fits) in the housing from plastic material to ensure a permanent force on the sealing are also not needed any further.

Therefore, a first aspect of the present disclosure is related to a method for fabricating a semiconductor module, the method comprising providing a substrate comprising a ceramic layer, a first metallic layer disposed on a first face of the ceramic layer, and a second metallic layer disposed on a second face of the ceramic layer, connecting a semiconductor die to the first metallic layer of the substrate, applying a closed sealing ring to a cover part, connecting the cover part to the substrate so that the closed sealing ring is connected with the ceramic layer of the substrate, covering the semiconductor die and the substrate with an encapsulant, and curing the encapsulant.

According to an embodiment of the method of the first aspect, the method further comprises applying a further sealing member to the cover part, and connecting the cover part to the substrate so that the further sealing member is connected with the ceramic layer of the substrate. According to a further example thereof, the further sealing member is configured to prohibit a movement of the substrate when the substrate is in contact with the closed sealing ring. According to a further example thereof, the further sealing member is configured to act as a counter force element. According to a further example thereof, the further sealing member does not have to have the form of a closed ring. It is rather sufficient if it is provided in the form of four separate sections along the four inner walls of the cover part.

According to an embodiment of the method of the first aspect, the cover part comprises an inner horizontal circumferential shoulder portion and an adjoining vertical end portion, wherein the closed sealing ring is attached to the shoulder portion and the further sealing member is attached to the vertical end portion.

According to an embodiment of the method of the first aspect, the closed sealing ring is the only sealing element and is configured as a collapsible closed sealing ring. In particular, the sealing ring can be designed to be rotatable or collapsible so that, for example, during the process of joining the cover part to the substrate, the sealing ring is positioned between the two components in such a way that it performs its sealing function.

According to an embodiment of the method of the first aspect, the cover part comprises a protrusion at a lowermost end thereof. The protrusion may be configured to provide a snap fit between the cover part and the substrate.

According to an embodiment of the method of the first aspect, the substrate is one of a direct copper bond (DCB), an active metal brazed (AMB), or an insulated metal substrate (IMS).

A second aspect of the present disclosure is related to a semiconductor module, comprising a substrate comprising a ceramic layer, a first metallic layer disposed on a first face of the ceramic layer, and a second metallic layer disposed on a second face of the ceramic layer, a semiconductor die connected to the first metallic layer of the substrate, a cover part, a closed sealing ring applied to the cover part, wherein the cover part is connected to the substrate so that the closed sealing ring is connected with the ceramic layer of the substrate, and an encapsulant covering the semiconductor die and the substrate.

According to an embodiment of the semiconductor module of the second aspect, the semiconductor module further comprises a further sealing member applied to the cover part, wherein the further sealing member is connected with the ceramic layer of the substrate. According to a further example thereof, the further sealing member is configured to prohibit a movement of the substrate when the substrate is in contact with the closed sealing ring. According to a further example thereof, the further sealing member is configured to act as a counter force element.

According to an embodiment of the semiconductor module of the second aspect, the cover part comprises an inner horizontal circumferential shoulder portion and an adjoining vertical end portion, wherein the closed sealing ring is applied to the shoulder portion and the further sealing member is attached to the vertical end portion.

According to an embodiment of the semiconductor module of the second aspect, the closed sealing ring is the only sealing element and is shaped so that it engages in a recess of the cover part and surrounds the ceramic layer on several sides in a U-shape.

According to an embodiment of the semiconductor module of the second aspect, the substrate is one of a direct copper bond (DCB), an active metal brazed (AMB), or an insulated metal substrate (IMS).

According to an embodiment of the semiconductor module of the second aspect, the cover part comprises a protrusion at a lowermost end thereof, the protrusion acting as a snapfit between the substrate and the cover plate.

A third aspect of the present disclosure is related to a method for fabricating a semiconductor module, the method comprising providing a substrate comprising a ceramic layer, a first metallic layer disposed on a first face of the ceramic layer, and a second metallic layer disposed on a second face of the ceramic layer, connecting a semiconductor die to the first metallic layer of the substrate, applying a cover part to the substrate, the cover part comprises a circumferential vertical section, and deforming a lower end of the vertical section so that the lower end is pressed inward against the ceramic layer.

According to an embodiment of the method of the third aspect, deforming is performed by reheating and reforming.

A fourth aspect of the present disclosure is related to a semiconductor module comprising a substrate comprising a ceramic layer, a first metallic layer disposed on a first face of the ceramic layer, and a second metallic layer disposed on a second face of the ceramic layer, a semiconductor die connected to the first metallic layer of the substrate, a cover part connected with the substrate, the cover part comprising a circumferential section comprising a first vertical section and a second inclined section pressed against the ceramic layer.

According to an embodiment of the semiconductor package of the fourth aspect, the semiconductor module comprises a sealing ring disposed between the substrate and the cover plate.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.
Fig. 1 comprises Fig. 1A to 1C and shows a cross-sectional top view (A), a cross-sectional side view before joining substrate and cover plate (B), and a cross-sectional side view of a finished semiconductor module (C) according to an example of the first and second aspects wherein the further sealing member shows triangular or lamella geometries.
Fig. 2 comprises Fig. 2A to 2C and shows a cross-sectional top view (A), a cross-sectional side view before joining substrate and cover plate, and a cross-sectional side view of a finished semiconductor module (C) according to an example wherein the further sealing member shows round geometries.
Fig. 3 comprises Fig. 3A and 3B and shows a cross-sectional side view before joining substrate and cover plate (A), and a cross-sectional side view of a finished semiconductor module according to an example of the second aspect wherein the only sealing ring is rotatable or collapsible.
Fig. 4 shows a cross-sectional partial side view of a finished semiconductor module according to an example of the first and second aspects wherein the cover part comprises a protrusion acting as a snapfit at a lowermost end thereof.
Fig. 5 shows a cross-sectional side view of a section of a finished semiconductor module according to an example of the second aspect wherein the cover part comprises two parts.
Fig. 6 comprises Fig. 6A and 6B and shows cross-sectional side views for illustrating a process for deforming lower sections of a cover plate before the process (A) and after the process (B).

### DESCRIPTION OF EMBODIMENTS

In the following detailed description, reference is made to the accompanying drawings, which form a part hereof, and in which is shown by way of illustration specific embodiments in which the disclosure may be practiced. In this regard, directional terminology, such as "top", "bottom", "front", "back", "leading", "trailing", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

Moreover, the word "exemplary" is used herein to mean serving as an example, instance, or illustration. Any aspect or design described herein as "exemplary" is not necessarily to be construed as advantageous over other aspects or designs. Rather, use of the word exemplary is intended to present concepts in a concrete fashion. As used in this application, the term "or" is intended to mean an inclusive "or" rather than an exclusive "or". That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. In addition, the articles "a" and "an" as used in this application and the appended claims may generally be construed to mean "one or multiple" unless specified otherwise or clear from context to be directed to a singular form. Also, at least one of A and B or the like generally means A or B or both A and B.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

### DETAILED DESCRIPTION

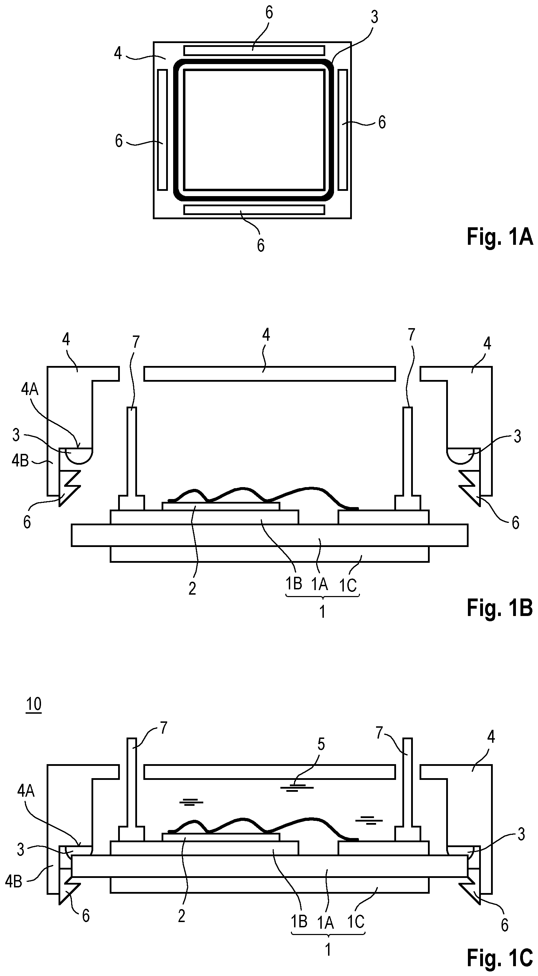

Fig. 1 comprises Fig. 1A to 1C and shows a cross-sectional top view (A), a cross-sectional side view before joining substrate and cover plate (B), and a cross-sectional side view of a finished semiconductor module (C) for illustrating a method for fabricating a semiconductor module wherein the further sealing member shows triangular or lamella geometries.

As can be seen in Fig. 1, fabricating a semiconductor module 10 comprises providing a substrate 1 comprising a ceramic layer 1A, a first metallic layer 1B disposed on a first face of the ceramic layer 1A, and a second metallic layer 1C disposed on a second face of the ceramic layer 1A, connecting a semiconductor die 2 to the first metallic layer 1B of the substrate 1, and applying a closed sealing ring 3 to a cover part 4, connecting the cover part 4 to the substrate 1 so that the closed sealing ring 3 is forced into contact with the ceramic layer 1A of the substrate 1, covering the semiconductor die 2 and the substrate with an encapsulant 5, and curing the encapsulant 5. The encapsulant 5 can be a gel, in particular a silicone gel. Electrical connectors in the form of vertical metallic pins 7 can be connected to different portions of the first metallic layer 1B of the substrate 1.

According to the example as shown in Fig. 1, the method further comprises applying a resilient member 6 to the cover part 4, and connecting the cover part 4 to the substrate 1 so that the resilient member 6 presses on the side of the ceramic layer 1A of the substrate 1 to hold it in place relative to cover part 4, thereby maintaining a compressive force on the sealing ring 3 between the substrate 1 and cover part 4.

The cover part 4 may comprise an inner horizontal circumferential shoulder portion 4A and an adjoining vertical end portion 4B, wherein the closed sealing ring 3 is attached to the shoulder portion 4A and the resilient member 6 is attached to the vertical end portion 4B.

The present disclosure thus offered here according to the example of Fig. 1 and the further examples describes solutions to attach a plastic housing in the form of the cover part 4 to a baseplateless module in the form of the substrate 1 without further mechanical elements like screws or rivets. The solutions presented here are very much specialized to 2C LSR injection molding processes which allow an easy push-in insertion of the substrate 1.

It is immediately obvious that in a module comprising only the sealing ring 3, a simple replacement of the ring by a static sealing is not possible, as the system is not able to apply a permanent mechanical load on the sealing which is needed to guarantee a tightness of the sealing.

Accordingly one needs a system which allows a simple push-in montage and guarantees tightness. When using the 2C LSR injection molding technology the space for solutions is enlarging. This is due to the fact that the mechanical properties between the cover part 4 which is a hard plastic part and the sealing ring 3 can differ very much.

In the approach as shown in Fig. 1 a housing comprises a hard plastic part in the form of the cover part 4 and a softer sealing part in the form of the closed sealing ring 3. Furthermore, the same material as used for the sealing ring 3 or a similar one can be used to create an element like the resilient member 6 which will act as a counter support. In this approach the closed sealing ring 3 element is used for the sealing only. Therefore, it needs to be arranged all over the connection surface, i.e. in a loop around the substrate 1, as can be seen in Fig. 1A. The resilient member 6 will only prohibit a movement of the substrate 1 when it is in contact to the sealing ring 3. This resilient member 6 will use the friction to keep the substrate 1 in place, when the encapsulant 5 is not yet cured. In the moment the encapsulant is hardened the sealing is not needed anymore at all. The resilient member 6 can be geometrically created in such a way that it allows an easy insertion of the substrate 1 and a more difficult removal of the substrate 1, after it is inserted between the sealing ring 3 and the further sealing member 6. This can be realized by the shown triangular or lamella geometries of the resilient member 6. It is not necessary that this element be arranged in a loop, and it may instead be positioned only in the edges without the corners as seen in Fig. 1A.

Both the closed sealing ring 3 and the resilient member 6 can be created by injection molding and subsequent curing, in particular by using a liquid silicone rubber (LSR). The particular composition of the LSR can be different for the sealing ring 3 and the resilient member 6.

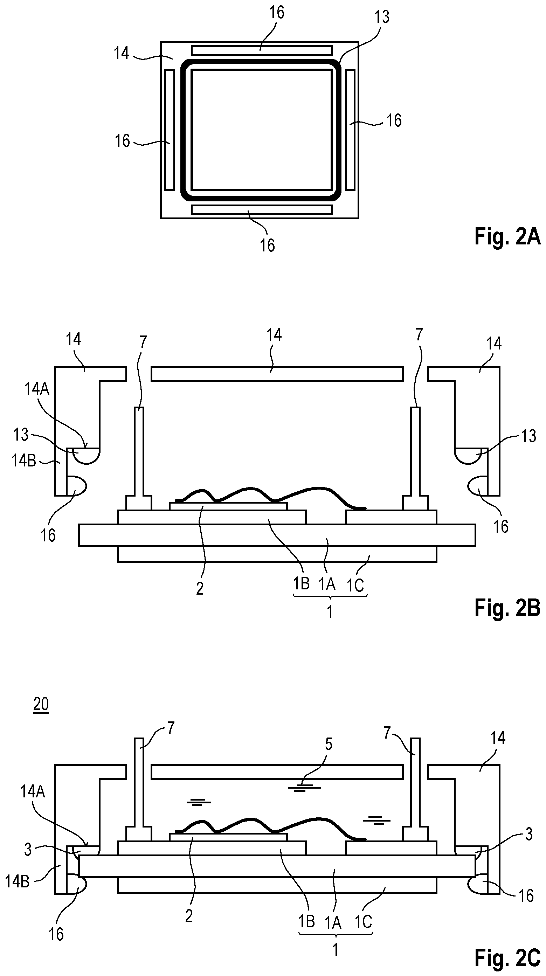

Fig. 2 comprises Fig. 2A to 2C and shows a cross-sectional top view (A), a cross-sectional side view before joining substrate and cover plate, and a cross-sectional side view of a finished semiconductor module (C) for illustrating a method for fabricating a semiconductor module according to an example wherein the further sealing member shows round geometries.

As can be seen in Fig. 2, fabricating a semiconductor module 20 comprises providing a substrate 1 comprising a ceramic layer 1A, a first metallic layer 1B disposed on a first face of the ceramic layer 1A, and a second metallic layer 1C disposed on a second face of the ceramic layer 1A, connecting a semiconductor die 2 to the first metallic layer 1B of the substrate 1, and applying a closed sealing ring 13 to a cover part 14, connecting the cover part 14 to the substrate 1 so that the closed sealing ring 13 is connected with the ceramic layer 1A of the substrate 1, covering the semiconductor die 2 and the substrate 1 with an encapsulant 5, and curing the encapsulant 5.

In a similar way as with the example of Fig. 1, also the fabrication of a semiconductor module 20 according to Fig. 2 includes a resilient member 16 which will act as a counter support. The resilient member 16 fulfills the same function as the resilient member 6 of Fig. 1. In particular, the resilient member 16 will prohibit a movement of the substrate 1 when it is in contact to the sealing ring 3. The further sealing member 16 will use friction and its position underneath the edge of the substrate 1 to keep the substrate 1 in place, when the encapsulant 15 is not yet is not yet cured.

Here, in the example of Fig. 2, the substrate 1 is pressed through a flexible opening between the sealing ring and the resilient member 16, which means that the LSR material forming the opening is replaced when the substrate 1 enters. When the substrate 1 has passed the opening the LSR of the opening can relax again and will therefore prohibit that the substrate 1 is moving out again. In this design the geometry is constructed in such a way that the substrate 1 after it has passed the opening will be pressed on the sealing ring 3. This force will be introduced by the LSR material of the opening. Similar to the example of Fig. 1, the resilient member 16 might be positioned only in the edges and not in the corners of the substrate 1, rather than forming a closed ring.

The cover part 14 comprises a horizontal shoulder portion 14A and and an adjoining vertical end portion 14B corresponding to those elements designated with reference signs 4A and 4B in Fig. 1.

For both solutions according to Figs. 1 and 2 the material properties need to be chosen in such a way that the substrate 1 is easily introduced past the resilient member 6,16, and that a force is needed to remove the substrate 1 again. The removal-force can be used as counter force for the sealing. It might be beneficial if the sealing ring 3 can be compressed more easily than the resilient member 6. Usually this can be realized by using different sealing geometries (e.g. height to width ratio) or even different materials (e.g. with different shore hardnesses).

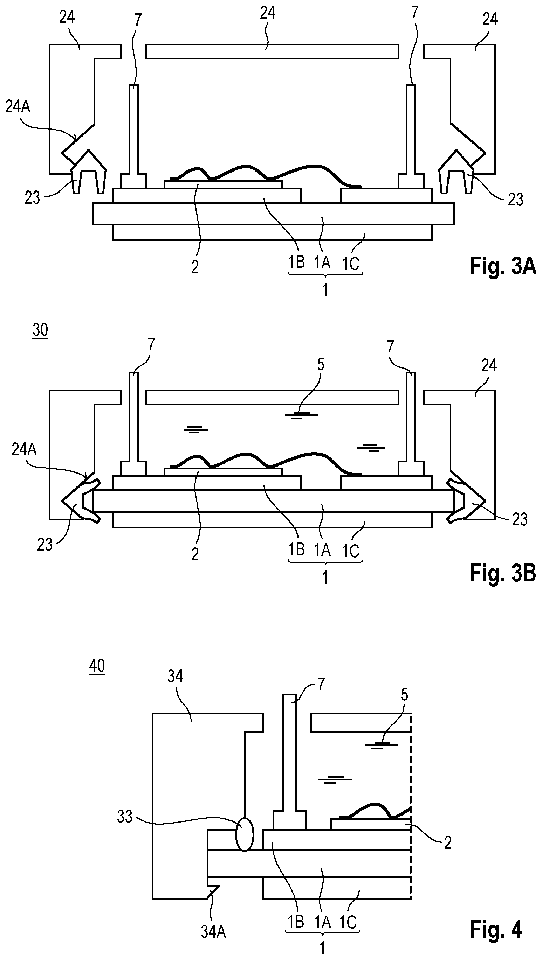

Fig. 3 comprises Fig. 3A and 3B and shows a cross-sectional side view before joining substrate and cover plate (A), and a cross-sectional side view of a finished semiconductor module (B) for illustrating a method for fabricating a semiconductor module according to an example wherein the only sealing ring is rotatable or collapsible.

As can be seen in Fig. 3, fabricating a semiconductor module 30 comprises providing a substrate 1 comprising a ceramic layer 1A, a first metallic layer 1B disposed on a first face of the ceramic layer 1A, and a second metallic layer 1C disposed on a second face of the ceramic layer 1A, connecting a semiconductor die 2 to the first metallic layer 1B of the substrate 1, and applying a closed sealing ring 23 to a cover part 24, connecting the cover part 24 to the substrate 1 so that the closed sealing ring 23 is connected with the ceramic layer 1A of the substrate 1. When getting into contact with the ceramic layer 1A the sealing ring 23 rotates about a connection line with the cover plate 4 so that a rear triangular section of the sealing ring 23 is moved into a congruent triangular recess 24A in the cover plate 24.

Accordingly Fig. 3 shows an alternative solution using only one sealing ring 23 without an extra resilient element for the counter force. The sealing ring 23 has a U-shaped cross-section, such that it can be placed around the outer geometry of the substrate 1. In order to reduce the effort at the mounting
process, the sealing ring 23 is designed to be collapsible. In the initial mounting state, the sealing ring 23 will be orientated with the U-shape face down as shown in Fig. 3A. This configuration allows to press the substrate 1 towards the sealing ring 23. With more force the sealing ring 23 will start to rotate around the connection line to the plastic material. It will thus keel over into a new orientation with the U-shape faced to the inside into a final mounting state. By this keel-over the ceramic layer 1A of the substrate 1 will be locked inside the U-shape of the sealing ring 23.

The cover part 24 and sealing ring 23 of Fig. 3 may be molded such that the U-shape of the sealing ring 23 is directed inward, corresponding to its final mounting state. In this case it will be necessary, manually or with appropriate tooling, to pivot the sealing ring 23 away from the cover part 24 into its initial mounting state. After the ceramic layer 1A of the substrate 1 is positioned inside the sealing ring 23, the sealing ring 23 may be simply released so that it assumes its final mounting state, locking the substrate 1 in place inside the U-shape of the sealing ring 23.

Alternatively, by using an appropriate design of the U-shape of the sealing ring 23, considering the material properties and the connection to the cover plate 4, the sealing ring 23 can be constructed like a toggle clamp. That means that two orientations, namely the ones shown in Fig. 3A and 3b, will be mechanically stable.

The examples as shown and described in connection with Figs. 1 to 3 here will replace the existing compound sealing by a static sealing. The technology will be possible for a subset of semiconductor power modules when a rivet or screw connection between the two partners, which are going to be sealed to each other is not necessary or not possible. The sealing in the context of a sealing against the non-cured dielectric gel is only needed until the gel is cured. But as the silicone material is able to cope with very high temperatures this sealing technology will still be working afterwards. In particular when replacing the gel component by a permanent liquid component a permanent sealing technology might be useful.

The technology of a static sealing at the lower part of the housing can also be used to create a sealing between the module and an open liquid cooling system. Current systems need an extra sealing ring to operate a module on an open cooling unit.

Also regarding noxious gases the sealing can be considered as sufficiently tight. Special materials for these properties are available. Of further interest might be the fact that this sealing technology will allow a certain flexibility of the substrate in the housing.

Fig. 4 shows a cross-sectional partial side view of a finished semiconductor module according to an example of the first and second aspects wherein the cover part comprises a protrusion acting as a snapfit at a lowermost end thereof.

As in the previously shown examples of Figs. 1 to 3, a semiconductor module 40 comprises a substrate 1 comprising a ceramic layer 1A, a first metallic layer 1B disposed on a first face of the ceramic layer 1A, and a second metallic layer 1C disposed on a second face of the ceramic layer 1A, a semiconductor die 2 applied to the first metallic layer 1B of the substrate 1, and a closed sealing ring 33 applied to a cover part 34 wherein the cover part 34 is applied to the substrate 1 so that the closed sealing ring 33 is connected with the ceramic layer 1A of the substrate 1. Cover part 34 and sealing ring 33 can have the same or similar properties as cover part 4 and sealing ring 33 of Fig. 1.

The special feature of the semiconductor module 40 of Fig. 4 is that, in addition to the sealing ring 33, cover part 34 comprises a protrusion 34A which serves as a snapfit connection. The snapfit connection is configured and designed so that it allows the substrate 1 to enter, but not to leave. In order to serve this purpose properly, a maximum height of the protrusion 34A may not succeed the height of the lower copper layer. Furthermore the protrusion 34A may comprise a triangular shape with a horizontal upper wall and an inclined lower wall to facilitate the entry of the substrate 1.

As in the previous examples, the semiconductor module 40 furthermore comprises an encapsulant 5 which can be a gel, in particular a silicone gel, and electrical connectors in the form of vertical metallic pillars 7 connected to different portions of the first metallic layer 1B of the substrate 1.

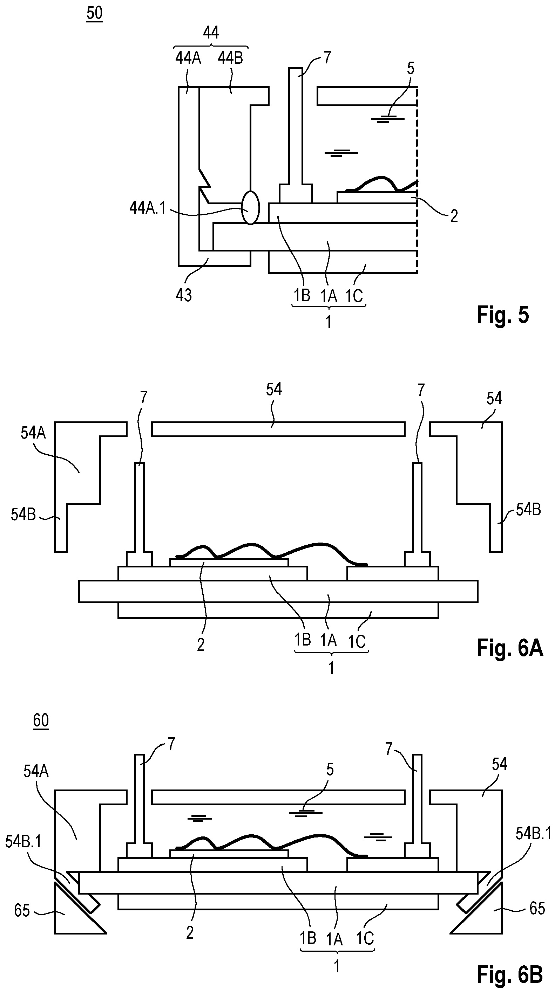

Fig. 5 shows a cross-sectional side view of a section of a finished semiconductor module according to an example of the first and second aspects wherein the cover part comprises two parts.

As in the previously shown examples of Figs. 1 to 3, a semiconductor module 50 comprises a substrate 1 comprising a ceramic layer 1A, a first metallic layer 1B disposed on a first face of the ceramic layer 1A, and a second metallic layer 1C disposed on a second face of the ceramic layer 1A, a semiconductor die 2 applied to the first metallic layer 1B of the substrate 1. Furthermore, the semiconductor module 50 comprises a cover part 44 and a closed sealing ring 43 applied to the cover part 44 wherein the cover part 44 is applied to the substrate 1 so that the closed sealing ring 43 is connected with the ceramic layer 1A of the substrate 1.

The special feature of the semiconductor module 50 of Fig. 5 is that the cover part 44 comprises two parts 44A and 44B wherein the first part 44A can have the same or similar features as the cover part 4 of Fig. 1 and the second part carries the closed sealing ring 43. The first part 44A further comprises a snapfit connection element 44A.1 in the form of a horizontal bar 44A.1 applied at the lowermost end of the first part 44A. When getting over the snapfit connection 44A.1 a permanent load will be applied on the static sealing. Although this technology needs a mechanical element below the substrate 1 with a thickness smaller than roughly 0.3mm is it technically solvable. This is due to the fact, that the mechanical force element below the substrate can be extended over the whole range of the substrate edge and it might be very stiff, as there is no need for a mechanical flexibility in this region (in comparison to the snapfit connection 34A as shown in Fig. 4).

Fig. 6 comprises Fig. 6A and 6B and shows cross-sectional side views for illustrating a process for deforming lower sections of a cover plate before the process (A) and after the process (B).

As in the previously shown examples of Figs. 1 to 3, a semiconductor module 60 comprises a substrate 1 comprising a ceramic layer 1A, a first metallic layer 1B disposed on a first face of the ceramic layer 1A, and a second metallic layer 1C disposed on a second face of the ceramic layer 1A, a semiconductor die 2 applied to the first metallic layer 1B of the substrate 1. Furthermore, the semiconductor module 50 comprises a cover part 54 applied to the substrate 1 and connected with the ceramic layer 1A of the substrate 1. The cover part 54 comprises a circumferential section 54 comprising a vertical part 54A and an inclined part 54B.1, which is pressed inward against the ceramic layer 1A.

In order to achieve the needed mechanical stability between the cover part 54 housing and the substrate 1 such alternative techniques can be applied. Very popular in the industry are so called compression molding processes. In the present example, a preformed plastic cover part 54 can be reheated and preformed. By using this technique, the preformed cover part 54 might have a form similar to the cover parts of the previously shown examples, the cover part 54 comprising a thick first vertical part 54A and a thinner vertical part 54B at the side of the substrate 1. The substrate 1 and the preformed cover part 54 can be stacked on top of each other such that the entire power module can be entered into a mold for performing the compression molding process. Here the vertical part 54B of the preformed cover part 54 are reheated and reformed within the mold and will be turned to inclined or folded sections 54B.1 pressed against the ceramic layer 1A thereby creating a form-fit connection to the substrate 1. This technique does not necessarily need a sealing material at all. In case a higher level of tightness is needed a static sealing (e.g. 2C LSR) can optionally be attached to the preformed cover plate 54.

To reform the vertical sections 54B of the preformed cover plate 54, special pressing elements 65 may be used in the mold to press the vertical sections 54B against the ceramic layer 1A during reheating. The lower vertical sections 54B may extend beyond the ceramic layer 1A of the substrate 1 as shown in Fig. 6A.

### EXAMPLES

In the following specific examples of the present disclosure are described.

Example 1 is a method for fabricating a semiconductor module, the method comprising providing a substrate comprising a ceramic layer, a first metallic layer disposed on a first face of the ceramic layer, and a second metallic layer disposed on a second face of the ceramic layer, connecting a semiconductor die to the first metallic layer of the substrate, applying a closed sealing ring to a cover part, mechanically connecting the cover part to the substrate so that the closed sealing ring is connected with the ceramic layer of the substrate, covering the semiconductor die and the substrate with an encapsulant, and curing the encapsulant.

Example 2 is the method according to Example 1, further comprising applying a resilient member to the cover part, and connecting the cover part to the substrate so that the further sealing member is connected with the ceramic layer of the substrate.

Example 3 is the method according to Example 2, wherein the resilient member is configured to prohibit a movement of the substrate when the substrate is in contact with the closed sealing ring.

Example 4 is the method according to Example 2 or 3, wherein the resilient member is configured to act as a counter force element.

Example 5 is the method according to any one of Examples 2 to 4, wherein the cover part comprises an inner horizontal circumferential shoulder portion and an adjoining vertical end portion, wherein the closed sealing ring is attached to the shoulder portion and the resilient member is attached to the vertical end portion.

Example 6 is the method according to any one of the preceding Examples, wherein the cover part is connected to the ceramic layer of the substrate by rotating the closed sealing ring into a mounting position which locks the substrate into place within the sealing ring.

Example 7 is the method according to any one of the preceding Examples, wherein the cover part comprises a protrusion at a lowermost end thereof.

Example 8 is the method according to any one of the preceding Examples, wherein the substrate is one of a direct copper bond (DCB), an active metal brazed (AMB), or an insulated metal substrate (IMS).

Example 9 is a semiconductor module comprising a ceramic layer, a first metallic layer disposed on a first face of the ceramic layer, and a second metallic layer disposed on a second face of the ceramic layer, a semiconductor die connected to the first metallic layer of the substrate, a cover part, a closed sealing ring applied to the cover part, wherein the cover part is mechanically connected to the substrate so that the closed sealing ring is connected with the ceramic layer of the substrate, and an encapsulant covering the semiconductor die and the substrate.

Example 10 is the semiconductor module according to Example 9, further comprising a resilient member applied to the cover part, wherein the resilient member is connected with the ceramic layer of the substrate.

Example 11 is the semiconductor module according to Example 10, wherein the resilient member is configured to prohibit a movement of the substrate when the substrate is in contact with the closed sealing ring.

Example 12 is the semiconductor module according to Example 10 or 11, wherein the resilient member is configured to act as a counter force element.

Example 13 is the semiconductor module according to any one of Examples 10 to 12, wherein the cover part comprises an inner horizontal circumferential shoulder portion and an adjoining vertical end portion, wherein the closed sealing ring is applied to the shoulder portion and the further sealing member is attached to the vertical end portion.

Example 14 is the semiconductor module according to any one of Examples 9 to 13, wherein the closed sealing ring is shaped so that it engages in a recess of the cover part and has a U-shaped cross-section locking the ceramic layer of the substrate within the sealing ring.

Example 15 is the semiconductor module according to any one of Examples 9 to 14, wherein the substrate is one of a direct copper bond (DCB), an active metal brazed (AMB), or an insulated metal substrate (IMS).

Example 16 is the semiconductor module according to any one of Examples 9 to 15, wherein the cover part comprises a protrusion at a lowermost end thereof.

Example 17 is a method for fabricating a semiconductor module, the method comprising providing a substrate comprising a ceramic layer, a first metallic layer disposed on a first face of the ceramic layer, and a second metallic layer disposed on a second face of the ceramic layer, connecting a semiconductor die to the first metallic layer of the substrate, applying a cover part to the substrate, the cover part comprises a circumferential vertical section, and deforming a lower end of the vertical section so that the lower end is pressed inward against the ceramic layer.

Example 18 is the method according to Example 17, wherein deforming is performed by reheating and reforming.

Example 19 is a semiconductor module comprising a substrate comprising a ceramic layer, a first metallic layer disposed on a first face of the ceramic layer, and a second metallic layer disposed on a second face of the ceramic layer, a semiconductor die connected to the first metallic layer of the substrate, a cover part connected with the substrate, the cover part comprising a circumferential section comprising a first vertical section and a second inclined section pressed against the ceramic layer.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A method for fabricating a semiconductor module, the method comprising
- providing a substrate (1) comprising a ceramic layer (1A), a first metallic layer (1B) disposed on a first face of the ceramic layer (1A), and a second metallic layer (1C) disposed on a second face of the ceramic layer (1A);
- connecting a semiconductor die (2) to the first metallic layer (1B) of the substrate (1);
- applying a closed sealing ring (3) to a cover part (4);
- mechanically connecting the cover part (4) to the substrate (1) so that the closed sealing ring (3) is connected with the ceramic layer (1A) of the substrate (1);
- covering the semiconductor die (2) and the substrate with an encapsulant (5); and
- curing the encapsulant (5).

2. The method according to claim 1, further comprising
- applying a resilient member (6) to the cover part (4); and
- connecting the cover part (4) to the substrate (1) so that the further sealing member (6) is connected with the ceramic layer (1A) of the substrate (1).

3. The method according to claim 2, wherein
the resilient member (6) is configured to prohibit a movement of the substrate (1) when the substrate (1) is in contact with the closed sealing ring (3).

4. The method according to claim 2 or 3, wherein
the resilient member (6) is configured to act as a counter force element.

5. The method according to any one of claims 2 to 4, wherein the cover part (4) comprises an inner horizontal circumferential shoulder portion (4A) and an adjoining vertical end portion (4B), wherein
the closed sealing ring (3) is attached to the shoulder portion (4A) and the resilient member (6) is attached to the vertical end portion (4B).

6. The method according to any one of the preceding claims, wherein the cover part (4) is connected to the ceramic layer 1A of the substrate (1) by rotating the closed sealing ring (23) into a mounting position which locks the substrate 1 into place within the sealing ring (23).

7. The method according to any one of the preceding claims, wherein
the cover part (34) comprises a protrusion (34A) at a lowermost end thereof.

8. The method according to any one of the preceding claims, wherein
the substrate (1) is one of a direct copper bond (DCB), an active metal brazed (AMB), or an insulated metal substrate (IMS) .

9. A semiconductor module (10), comprising
- a substrate (1) comprising a ceramic layer (1A), a first metallic layer (1B) disposed on a first face of the ceramic layer (1A), and a second metallic layer (1C) disposed on a second face of the ceramic layer (1A);
- a semiconductor die (2) connected to the first metallic layer (1B) of the substrate (1);
- a cover part (4);
- a closed sealing ring (3) applied to the cover part (4), wherein the cover part (4) is mechanically connected to the substrate (1) so that the closed sealing ring (3) is connected with the ceramic layer (1A) of the substrate (1); and
- an encapsulant (5) covering the semiconductor die (2) and the substrate (1).

10. The semiconductor module (10) according to claim 9, further comprising
- a resilient member (6) applied to the cover part (4), wherein
- the resilient member (6) is connected with the ceramic layer (1A) of the substrate (1).

11. The semiconductor module (10) according to claim 10, wherein
the resilient member (6) is configured to prohibit a movement of the substrate (1) when the substrate (1) is in contact with the closed sealing ring (3).

12. The semiconductor module (10) according to claim 10 or 11, wherein
the resilient member (6) is configured to act as a counter force element.

13. The semiconductor module (10) according to any one of claims 10 to 12, wherein
the cover part (4) comprises an inner horizontal circumferential shoulder portion (4A) and an adjoining vertical end portion (4B), wherein
the closed sealing ring (3) is applied to the shoulder portion (4A) and the further sealing member (6) is attached to the vertical end portion (4B).

14. The semiconductor module (30) according to any one of claims 9 to 13, wherein
the closed sealing ring (23) is shaped so that it engages in a recess (24A) of the cover part (24) and has a U-shaped cross-section locking the ceramic layer (1A) of the substrate (1) within the sealing ring (23).

15. The semiconductor module (10) according to any one of claims 9 to 14, wherein
the substrate (1) is one of a direct copper bond (DCB), an active metal brazed (AMB), or an insulated metal substrate (IMS) .

16. The semiconductor module (40) according to any one of claims 9 to 15, wherein
the cover part (34) comprises a protrusion (34A) at a lowermost end thereof.

17. A method for fabricating a semiconductor module, the method comprising
- providing a substrate (1) comprising a ceramic layer (1A), a first metallic layer (1B) disposed on a first face of the ceramic layer (1A), and a second metallic layer (1C) disposed on a second face of the ceramic layer (1A);
- connecting a semiconductor die (2) to the first metallic layer (1B) of the substrate (1);
- applying a cover part (54) to the substrate (1), the cover part (54) comprises a circumferential vertical section (54A); and
- deforming a lower end of the vertical section (54A) so that the lower end is pressed inward against the ceramic layer (1A) .

18. The method according to claim 17, wherein
deforming is performed by reheating and reforming.

19. A semiconductor module (60) comprising
- a substrate (1) comprising a ceramic layer (1A), a first metallic layer (1B) disposed on a first face of the ceramic layer (1A), and a second metallic layer (1C) disposed on a second face of the ceramic layer (1A);
- a semiconductor die (2) connected to the first metallic layer (1B) of the substrate (1);
- a cover part (54) connected with the substrate (1), the cover part (54) comprising a circumferential section comprising a first vertical section (54A) and a second inclined section (54B.1) pressed against the ceramic layer (1A).
